(19) Europäisches Patentamt

European Patent Office

Office européen des brevets

(11) Veröffentlichungsnummer: **0 368 800**
**A2**

(12) **EUROPÄISCHE PATENTANMELDUNG**

(21) Anmeldenummer: **89810810.5**

(22) Anmeldetag: **27.10.89**

(51) Int. Cl.⁵: **G03F 7/023**

(30) Priorität: **05.11.88 DE 3837612**

(43) Veröffentlichungstag der Anmeldung:
**16.05.90 Patentblatt 90/20**

(84) Benannte Vertragsstaaten:
**AT CH DE FR GB IT LI NL SE**

(71) Anmelder: **CIBA-GEIGY AG**
**Klybeckstrasse 141**
**CH-4002 Basel(CH)**

(72) Erfinder: **Sassmannshausen, Jörg**
**Schreberweg 40**
**D-6100 Darmstadt(DE)**
Erfinder: **Schulz, Reinhard, Dr.**
**Im Trappengrund 44**
**D-6107 Reinheim(DE)**
Erfinder: **Bartmann, Ekkehard, Dr.**
**Dieburger Weg 12a**
**D-6106 Erzhausen(DE)**

(54) **Positiv-Fotoresists vom Polyimid-Typ.**

(57) Die Erfindung betrifft positiv arbeitende, wässrig-alkalische entwickelbare Fotoresists zur Erzeugung von Reliefstrukturen aus hochwärmebeständigen Polyimid-Polymeren, enthaltend in einem organischen Lösungsmittel im wesentlichen mindestens je

a) ein in Polyimid überführbares Präpolymer,

b) eine strahlungsempfindliche Chinondiazid-Verbindung sowie gegebenenfalls weitere übliche Zusatzstoffe, in denen das Präpolymer ein vollständig verestertes Polyamidsäure-Polymer ist.

EP 0 368 800 A2

## Positiv-Fotoresists vom Polyimid-Typ

Die Erfindung betrifft Positiv-Fotoresists vom Polyimid-Typ mit Chinondiazid-Verbindungen als fotoaktive Komponente.

Als Fotoresists werden üblicherweise fotostrukturierbare organische Polymermaterialien bezeichnet, die in photolithographischen Prozessen und verwandten Techniken eingesetzt werden, beispielsweise bei der Herstellung von Druckplatten, von gedruckten elektrischen Schaltungen und Leiterplatten oder insbesondere in der Mikroelektronik bei der Herstellung von integrierten Halbleiterbauelementen.

Zur Erzeugung der Schaltungsstrukturen bei der Herstellung von integrierten mikroelektronischen Halbleiterbauelementen wird das Halbleitersubstratmaterial mit dem Fotoresist beschichtet; durch bildmässiges Belichten der Fotoresistschicht und anschliessendes Entwickeln werden dann Fotoresistreliefstrukturen erhalten. Diese dienen als Maske für die eigentlichen Strukturierungsprozesse am Halbleitersubstrat wie Ätzen, Dotieren, Beschichten mit Metallen, anderen Halbleiter- oder auch Isolatormaterialien. Danach werden die Fotoresistmasken in der Regel wieder entfernt. Durch eine Vielzahl derartiger Prozesszyklen entstehen auf dem Substrat die Schaltungsstrukturen der Mikrochips.

Es werden grundsätzlich zwei verschiedene Typen von Fotoresists unterschieden: Bei positiv arbeitenden Fotoresists werden die belichteten Bereiche durch einen Entwicklungsprozess abgelöst, während die unbelichteten Bereiche als Schicht auf dem Substrat verbleiben. Bei negativ arbeitenden Fotoresists verbleiben umgekehrt die bestrahlten Schichtbereiche als Reliefstruktur. Positiv-Fotoresists besitzen von ihrer Natur her eine höhere Bildauflösung und werden deshalb überwiegend bei der Herstellung von VLSI-Schaltungen (very large scale integration) eingesetzt.

Positiv-Fotoresists üblicher Art enthalten in einem organischen Lösungsmittel im wesentlichen mindestens je ein in wässrigen Alkalien lösliches Harz vom Novolak-Typ und eine fotoempfindliche Chinondiazidverbindung, die die Alkalilöslichkeit des Harzes reduziert. Durch Strahlungseinwirkung auf mit derartigen Zusammensetzungen erzeugte Fotoresistschichten wird die Alkalilöslichkeit in den belichteten Bereichen durch fotoinduzierte strukturelle Umwandlung der Chinondiazidverbindung in ein Carbonsäurederivat erhöht, so dass nach Entwicklung in wässrig-alkalischen Entwicklungsbädern positive Fotoresist-Reliefstrukturen erhalten werden.

Die ständig fortschreitende Miniaturisierung in der Halbleitertechnologie und Mikroelektronik stellt an die Fotoresist-Materialien und die damit darzustellenden Reliefstrukturen höchste Anforderungen.

Neben Empfindlichkeit, Auflösung und Kontrast des Fotoresist kommen der mechanischen und chemischen Stabilität des Fotoresist-Materials bzw. der erzeugten Reliefstrukturen während der weiteren Prozessschritte wie insbesondere Entwickeln und Plasmaätzen sowie der Dimensiontreue und Beständigkeit der Fotoresist-Reliefstrukturen bei Einwirkung erhöhter Temperaturen besondere Bedeutung zu.

Positiv-Fotoresist auf Basis von alkalilöslichem Novolak-Harz und Chinondiazidverbindungen haben aber normalerweise eine nicht ausreichende thermische Stabilität. Dies zeigt sich darin, dass sich bei Temperatureinwirkung von mehr als 120°C die Resiststrukturen durch Fliessvorgänge zu verformen beginnen, wodurch Kantenschärfe und Kantensteilheit aber auch die Geometrie der Strukturen leiden. Die Masshaltigkeit der Strukturübertragung auf das Substrat wird dadurch beeinträchtigt.

Üblicherweise werden die nach Belichtung und Entwicklung erhaltenen Fotoresist-Reliefstrukturen einem Erhitzungsschritt (post bake) unterzogen, bei dem Temperaturen deutlich über 100°C, meist zwischen 120° und 180°C, einwirken. Dieser Schritt dient der Ausheizung von noch enthaltenen flüchtigen Bestandteilen, wodurch eine bessere Substrathaftung und Härtung der Resiststrukturen und eine Verringerung der Erosion bei anschliessendem Plasmaätzschritten bewirkt werden soll. Aber auch während des Plamaätzens selbst werden am Substrat hohe Temperaturen, die nicht selten 200°C sogar deutlich überschreiten, erzeugt. Auch durch stabilisierende Zusätze und Nachbehandlungsmassnahmen lässt sich die Temperaturstabilität von Fotoresist auf Novolakharzbasis kaum über ca. 180°C heben.

Polyimid- und Polyimid-verwandte Polymere verfügen naturgemäss über eine besonders ausgeprägte Hitze- und Chemikalienbeständigkeit. Derartige Materialien überstehen selbst Temperaturen von etwa 400°C über einen längeren Zeitraum unbeschadet. Als schichtbildende Komponenten für Fotoresists zur Erzeugung hochwärmebeständiger Strukturen sind sie daher vorzüglich geeignet.

Unter Fotoresists vom Polyimid-Typ sind ganz allgemein solche Materialien zu verstehen, deren schichtbildende Hauptkomponenten lösliche und gegebenenfalls fotopolymerisierbare Polyimide oder Polyamidsäure- bzw. Polyamidsäurederivat-Präpolymere sind, die sich in hochwärmebeständige Polymere vom Polyimid-Typ überführen lassen.

Fotoresists vom Polyimid-Typ werden deshalb vornehmlich dort eingesetzt, wo es gerade auf diese besonderen Eigenschaften ankommt, und hochwärmebeständige Fotopolymer-Reliefstrukturen und -Beschichtungen erzeugt werden sollen.

Die bekannten und in der Praxis auch hauptsächlich eingesetzten Fotoresists vom Polyimid-Typ sind negativ arbeitend. Ihre auf in Polyimide überführbare Präpolymere basierenden schichtbildenden Komponenten sind fotovernetzbar; für eine effektive Fotovernetzung enthalten sie radikalbildende Fotoinitiatoren. Derartige Fotoresists leiten sich überwiegend von den Grundsystem ab, wie sie in den Patentschriften DE-PS 23 08 830 und DE-PS 24 37 340 beschrieben sind. Sie enthalten Polyamidsäureester, die ethylenisch ungesättigte strahlungsvernetzbare Gruppen wie vorzugsweise Allyloxy- oder (Meth)-Acryloyloxy-Gruppen aufweisen, sowie Fotoinitiatoren und gegebenenfalls weitere fotopolymerisierbare Verbindungen, Fotosensibilisatoren, Farbstoffe und modifizierende Additive. Dem Vorteil der hohen Wärmebeständigkeit von Fotoresists vom Polyimid-Typ steht die eingeschränkte Auflösung aufgrund ihrer Negativarbeitsweise entgegen. Es hat daher nicht an Versuchen gefehlt, positiv arbeitende Fotoresists vom Polyimid-Typ zu entwickeln, wobei allerdings immer von Polyimid-Präpolymeren ausgegangen worden ist, die keine fotopolymerisierbaren Gruppen oder Anteile enthielten.

So sind beispielsweise in DE-OS 26 31 535 und in JP 58-160348 Positivfotoresistsysteme beschrieben, die als Harzkomponenten Polyamidsäuren und als fotoaktive Komponente Chinondiazid-Verbindungen enthalten. Es hat sich aber gezeigt, wie etwa in EP 0 023 662 klar zum Ausdruck gebracht, dass derartige Resistformulierungen nur begrenzt lagerfähig sind, da Chinondiazid-Verbindungen in Gegenwart von Säure sich relativ rasch zersetzen. Ferner sind die Löslichkeitsunterschiede zwischen den belichteten und unbelichteten Teilen solcher Fotoresists relativ gering und ihre Stabilität gegenüber alkalischen Entwickler- und Ätzlösungen ist ungenügend.

In EP 0 224 680 sind verbesserte Systeme dieser Art beschrieben, in denen der Säureanteil im Polyimid-Präpolymer reduziert ist, etwa durch partielle Imidisierung, partielle Neutralisierung mit basischen Zusätzen sowie partielle Veresterung der Polyamidsäurefunktion oder durch Verschneiden mit Polyamidsäureestern.

Aber auch diese Systeme enthalten beträchtliche, offenbar als notwendig erachtete Anteile von Polyamidsäure, so dass die oben genannten Probleme, insbesondere die der nicht ausreichenden Lagerstabilität, noch nicht zufriedenstellend gelöst sind.

Der vorliegenden Erfindung lag daher die Aufgabe zugrunde, positiv arbeitende Fotoresists vom Polyimid-Typ zu entwickeln, die den bekannten derartigen Systemen überlegen sind, insbesondere im Hinblick auf die Lagerstabilität.

Überraschend wurde nun gefunden, dass sich mit vollständig veresterten Polyamidsäure-Präpolymeren und strahlungsempfindlichen Chinondiazid-Verbindungen positiv arbeitende, wässrig-alkalisch entwickelbare Fotoresists vom Polyimid-Typ formulieren lassen und dass derartige Formulierungen eine ausgezeichnete Lagerstabilität besitzen.

Gegenstand der Erfindung sind daher positiv arbeitende, wässrig-alkalische entwickelbare Fotoresists zur Erzeugung von Reliefstrukturen aus hochwärmebeständigen Polyimid-Polymeren, enthaltend in einem organischen Lösungsmittel im wesentlichen mindestens je
   a) ein in Polyimid überführbares Präpolymer,
   b) eine strahlungsempfindliche Chinondiazid-Verbindung sowie gegebenenfalls weitere übliche Zusatzstoffe, dadurch gekennzeichnet, dass das Präpolymer ein vollständig verestertes Polyamidsäure-Polymer ist.

Gegenstand der Erfindung ist weiterhin ein Verfahren zur Herstellung von Reliefstrukturen aus hochwärmebeständigen Polyimid-Polymeren durch Beschichten eines Substrates mit einer Fotoresistlösung, Trocknen der Schicht, bildmässiges Belichten der Schicht mit UV-Strahlung einer Wellenlänge zwischen etwa 250 und 450 nm, Entwicklung durch Ablösen der bestrahlten Schichtteile mit einer wässrig-alkalischen Entwicklerlösung sowie Tempern der erhaltenen Reliefstrukturen, dadurch gekennzeichnet, dass ein positiv arbeitender Fotoresist verwendet wird, der ein vollständig verestertes Polyamidsäure-Polymer als ein in Polyimid überführbares Präpolymer und eine strahlungsempfindliche Chinondiazid-Verbindung enthält.

In den erfindungsgemässen Positiv-Fotoresists vom Polyimid-Typ ist die schichtbildende Komponente im wesentlichen ein in hochwärmebeständiges Polyimid-Polymer überführbares Polyamidsäureester-Präpolymer mit vollständiger Veresterung. Im Prinzip kommen hierfür alle derartigen bekannten Präpolymere in Frage, wie sie etwa in den eingangs zitierten Publikationen vielfältig beschrieben sind. Ganz allgemein handelt es sich hierbei um Polykondensations- oder Polyadditionsprodukte von tetrafunktionellen aromatischen Verbindungen, die zwei zu Polykondensations- bzw. Polyadditionsreaktionen befähigte funktionelle Gruppen und zwei zu diesen benachbarte vollständig veresterte Carboxyl-Gruppen aufweisen, mit entsprechend umsetzbaren difunktionellen aromatischen Verbindungen wie aromatischen Diaminen, Diisocyanaten, Dicarbonsäuren oder Bis-Carbonsäurechloriden. Überwiegend leiten sich die resultierenden Polyamidsäureester-Präpolymere von ein- oder zweikernigen Tetracarbonsäuren und ein- oder zweikerni-

3

gen Diaminen ab. Die zugrundeliegenden Tetracarbonsäuren sind vorzugsweise Pyromellithsäure oder 3,3',4,4'-Benzophenontetracarbonsäure; die zugrundeliegenden Diamine sind vorzugsweise 4,4'-Diaminodiphenylether, 4,4'-Diaminodiphenylmethan und 4,4'-Diaminodiphenylsulfon. Ganz besonders bevorzugt sind Präpolymere, denen Pyromellithsäure oder 3,3',4,4'-Benzophenontetracarbonsäure und 4,4'-Diaminodiphenylether zugrundeliegen. Diese Präpolymere sind in einfacher Weise, wie etwa in den eingangs zitierten Publikationen beschrieben, durch Umsetzung äquimolarer Menge der Dianhydride der zugrundeliegenden Tetracarbonsäuren mit den entsprechenden Diaminen herstellbar. Werden die jeweiligen zwei Carbonsäurereste, die pro Tetracarbonsäureeinheit für die Polyamidbindung nicht benötigt werden, vorher oder im weiteren Verlauf zusätzlich einer Veresterung unterzogen, so resultieren die entsprechenden Polyamidsäureester-Präpolymere. Vollständige Veresterung im Sinne der Erfindung liegt vor, wenn mindestens 95 %, vorzugsweise 98-100 %, aller Carboxylgruppen verestert sind. Bei diesen Polyamidsäureestern handelt es sich vornehmlich um die Ester niederer aliphatischer Alkohole, wie Methanol und Ethanol; es können auch die aus DE-PS 24 37 348 bekannten ungesättigten Ester von Glycolmonoallylether oder 2-Hydroxyethylmethacrylat sein. Besonders bevorzugt als schichtbildende Komponenten für die erfindungsgemässen Positiv-Fotoresists vom Polyimid-Typ sind die aus Pyromellith säuredianhydrid bzw. 3,3',4,4'-Benzophenontetracarbonsäuredianhydrid und 4,4'-Diaminodiphenylether herstellbaren Polyamidsäure-Methacryloyloxyethylester.

Die in den erfindungsgemässen Positiv-Fotoresists vom Polyimid-Typ einzusetzenden Polyamidsäureester-Präpolymere können in einem weiten Bereich variierende Molmassen aufweisen. Wesentliche Voraussetzung ist nur, dass sie in üblichen Lösungsmitteln ausreichend löslich sind und bei der Beschichtung nach dem Abdunsten des Lösungsmittels eine trockene feste Schicht bilden. Vorzugsweise liegen die Molmassen im Bereich zwischen 5 000 und 100 000, insbesondere zwischen 10 000 und 30 000. In den erfindungsgemässen Fotoresists liegt das Präpolymer üblicherweise in einem Anteil von 45-95 Gew.%, vorzugsweise 50-90 Gew.%, bezogen auf den Gesamtgehalt der Fotoresistlösung, vor.

Als fotoempfindliche Chinondiazid-Verbindungen sind in den erfindungsgemässen Positiv-Fotoresists vom Polyimid-Typ Veresterungsprodukte der 1,2-Naphthochinon-2-diazid-5-sulfonsäure oder 1,2-Naphthochinon-2-diazid-4-sulfonsäure mit niedermolekularen aromatischen Hydroxyverbindungen, insbesondere Hydroxybenzophenonen, wie 2,3,4-Trihydroxybenzophenon und 2,3,4,4'-Tetrahydroxybenzophenon, sowie Trihydroxybenzolen, wie 1,3,5-Trihydroxybenzol, im Gebrauch. Diese Naphthochinondiazidverbindungen verfügen über eine breite Absorption im nahen bis mittleren UV-Wellenlängenbereich zwischen ca. 300 und 450 nm. In diesem Wellenlängenbereich liegen kräftige Emissionslinien der üblicherweise in den Projektionsgeräten eingesetzten Quecksilberlampen, wie etwa die Linien bei 313 nm, 334 nm, 365 nm, 405 nm und 436 nm. Diese Verbindungen haben einen Anteil im Fotoresist von 5-55 Gew.%, vorzugsweise 10-30 Gew.%, bezogen auf den Gesamtfeststoffgehalt.

Als fotoempfindliche Komponenten werden in den erfindungsgemässen Positiv-Fotoresists vom Polyimid-Typ bevorzugt 1,2-Naphthochinondiazid-5-sulfonylester von Trihydroxybenzol-Isomeren eingesetzt. Es können dies sein die Triester von 1,2,3-, 1,2,4-und 1,3,5-Trihydroxybenzol. Diese Verbindungen sind bekannt und können in einfacher Weise durch Veresterung der entsprechenden Trihydroxybenzol-Isomeren mit 1,2-Naphthochinondiazid-5-sulfonylchlorid als reine Vollester erhalten werden. Die isomeren Formen dieser Triester werden normalerweise rein eingesetzt, können aber auch im Gemisch miteinander verwendet werden. Ihr Einsatz in den erfindungsgemässen Positiv-Fotoresists erfolgt vorzugsweise in einem Anteil, so dass für die fotobleichbare Absorption (A-Wert) ein Absorptionskoeffizient von mindestens 0,4 $\mu m^{-1}$ resultiert.

Vorzugsweise liegt der einzustellende A-Wert im Bereich zwischen 0,50 und 0,75 $\mu m^{-1}$ bei einer Bestrahlungswellenlänge von 436 nm. Dies ist in Abhängigkeit der geringfügig variierenden molaren Extinktionen dieser Isomeren ab einem Gehalt von etwa 15 Gew.%, bezogen auf den Gesamtfeststoffgehalt, der Fall. Besonders bevorzugt als strahlungsempfindliche Komponente ist der 1,2-Naphthochinondiazid-5-suflonyltrisester von 1,3,5-Triyhdroxybenzol. Dieser wird vorzugsweise in einer Konzentration von 17-30 Gew.%, bezogen auf den Gesamtfeststoffgehalt, eingesetzt.

Als Lösungsmittel zur Herstellung der Fotoresistlösung sind im Prinzip alle Lösungsmittel geeignet, in denen die nicht flüchtigen Fotoresistbestandteile, wie Präpolymer, Chinondiazid-Verbindung und gegebenenfalls weitere Zusatzstoffe, ausreichend löslich sind und die mit diesen Bestandteilen nicht irreversibel reagieren. In Frage kommen hierfür beispielsweise aprotische polare Lösungsmittel, wie Dimethylformamid, Dimethylacetamid, N-Methylpyrrolidon, Hexamethylphosphorsäuretriamid und Butyrolacton, aliphatische Ketone, wie Methylethylketon, Cyclopentanon oder Cyclohexanon, aliphatische Ester, wie Ethylacetat oder Butylacetat, Ether, wie Dioxan oder Tetrahydrofuran, Mono- oder Bisether sowie Ether- oder Esterderivate von Glycloverbindungen, wie Ethylenglycolmonomethylether, Ethylenglycoldimethylether, Ethoxyethylacetat oder Methoxypropylacetat, des weiteren Monooxocarbonsäureester, wie Milchsäureethylester oder 2-Ethox-

4

ypropionsäureethylester. Vielfach werden auch Gemische aus den genannten Lösungsmitteln verwendet. Bevorzugt enthalten die erfindungsgemässen Fotoresists N-Methylpyrrolidon und Cyclopentanon als Lösungsmittel. Das Lösungsmittel hat üblicherweise einen Anteil von 40-90 Gew.% an der gesamten Fotoresistlösung.

Zur Anpassung an die Erfordernisse des jeweiligen Einsatzzweckes können die erfindungsgemässen Fotoresists durch in dieser Technologie übliche Zusatzstoffe noch weiter modifiziert und beispielsweise hinsichtlich spektraler Empfindlichkeit, Eigenabsorption, Mindestbelichtungsenergie, der erzielbaren Bildauflösung und Kantenschärfe, der Beschichtungs- und Entwicklungseigenschaften optimiert werden.

Zu den weiteren üblichen Zusatzstoffen, die gegebenenfalls auch in den erfindungsgemässen Positiv-Fotoresists vom Polyimid-Typ enthalten sein können, gehören Haftvermittler, Verlaufmittel, Weichmacher, weitere filmbildende Harze, Tenside und Stabilisatoren. Zusätze dieser Kategorien sind dem Fachmann ausreichend bekannt und sind vielfältig in der einschlägigen Fachliteratur beschrieben. Der Anteil an solchen Zusätzen übersteigt zusammengenommen kaum 25 Gew.% bezogen, auf den Gesamtfeststoffgehalt der Fotoresistlösung.

Die Formulierung der erfindungsgemässen Fotoresists erfolgt in an sich bekannter Weise durch Mischen bzw. Lösen der Komponenten in dem Lösungsmittel bzw. Lösungsmittelgemisch. Nach Lösung der Bestandteile im Lösungsmittel wird die erhaltene Fotoresistlösung je nach Anspruch an den Partikelgehalt durch Membranfilter mit einer Porenweite von 0.1-1 $\mu$m filtriert. Üblicherweise wird der Gesamtfeststoffgehalt des Fotoresist auf die gewünschte Schichtdicke und Beschichtungsmethode abgestimmt.

Hauptanwendungsgebiet ist die Herstellung mikroelektronischer und optoelektronischer Schaltungen und Bauelemente. Hierbei können diese Materialien sowohl als temporäre Fotoresistmasken als auch als bleibende Strukturen fungieren, wie beispielsweise als Isolations-, Schutz- oder Passivierungsschichten, dielektrische Schichten oder bei Flüssigkristallanzeigeelementen als Orientierungsschichten. Polyimidmaterialien sind beispielsweise auch sehr gut geeignet zum Schutz von Halbleiterschaltungen vor $\alpha$-Strahlung.

Die Anwendung erfolgt nach an sich bekannten Verfahren und mit den hierfür üblichen Prozessgeräten durch Beschichten eines Substrates mit der Fotoresistlösung, Trocknen der Schicht bei erhöhter Temperatur, bildmässiges Belichten der Schicht mit Strahlung aus einem Wellenlängenbereich, in dem die Schicht empfindlich ist, Entwicklung durch Ablösen der bestrahlten Schichtteile und Tempern der erhaltenen Reliefstrukturen.

Als Substrate fungieren überwiegend Halbleiterscheiben, wie z.B. Silizium-Wafer, die gegebenenfalls mit einer Schicht aus Siliziumdioxid, Siliziumnitrid oder Aluminium überzogen sind. Auch andere bei der Herstellung miniaturisierter Schaltungen übliche Materialien, wie Germanium, Galliumarsenid, Keramik mit gegebenenfalls Edelmetallbeschichtung, kommen in Frage.

Die Beschichtung erfolgt üblicherweise durch Tauchen, Sprühen, Walzen oder Aufschleudern. Bei der letzteren, am häufigsten angewandten Beschichtungsmethode, ist die resultierende Schichtdicke abhängig von der Viskosität der Fotoresistlösung, dem Feststoffgehalt und der Aufschleudergeschwindigkeit. Für den jeweiligen Fotoresist werden sogenannte Schleuderkurven ermittelt, aus denen sich die Resistschichtdicken in Abhängigkeit von Viskosität und Schleuderdrehzahl ermitteln lassen. Die erfindungsgemässen Fotoresists können vorteilhaft zur Erzeugung von Schichten und Reliefstrukturen mit Schichtdicken zwischen 0,1 und 500 $\mu$m eingesetzt werden. Dünne Schichten, etwa bei der Anwendung als temporäre Fotoresists oder als Isolationsschicht oder Dielektrikum, in Mehrlagenschaltungen liegen typisch zwischen 0,1 und 5 $\mu$m, insbesondere 1-2 $\mu$m. Dicke Schichten, etwa bei der Anwendung als Passivierschicht oder $\alpha$-Strahlungsschutz bei Halbleiterspeicherelementen liegen typisch zwischen 10 und 200 $\mu$m, insbesondere 20-100 $\mu$m.

Nachdem der Fotoresist auf das Substrat aufgebracht worden ist, wird er normalerweise bei Temperaturen zwischen 50 und 120°C vorgetrocknet. Dazu können Öfen oder Heizplatten verwendet werden. Die Trocknungszeit in Öfen liegt im Bereich von etwa 10-60 Minuten, kann aber bei dicken Schichten auch mehrere Stunden betragen. Auf Heizplatten liegt die Trocknungszeit normalerweise im Bereich von etwa 0,5-5 Minuten.

Anschliessend wird die Fotoresistschicht der Strahlung ausgesetzt. Üblicherweise wird aktinisches Licht verwendet, aber auch energiereiche Strahlung wie Röntgen- oder Elektronenbestrahlung kann verwendet werden. Die Bestrahlung oder Belichtung kann durch eine Maskenvorlage durchgeführt werden, es kann aber auch ein gebündelter Strahl der Strahlung über die Oberfläche der Fotoresistschicht geführt werden. Üblicherweise werden zur Bestrahlung UV-Lampen verwendet, die Strahlung einer Wellenlänge von 250-450 nm, vorzugsweise 300-400 nm, aussenden. Die Belichtung kann poly- oder monochromatisch erfolgen. Bevorzugt werden hierzu kommerziell erhältliche Belichtungsgeräte, wie z.B. Kontakt- und Abstandbelichtungsgeräte, Scanning-Projektions-Belichtungsgeräte oder Wafer-Stepper, eingesetzt.

Nach der Belichtung kann nun ein Bildmuster unter Freilegung von Teilen des Substrates entwickelt werden, indem die Schicht, z.B. durch Tauchen oder Besprühen, mit einer wässrig-alkalischen Entwicklerlö-

EP 0 368 800 A2

sung behandelt wird, die die bestrahlten Bereiche der Fotoresistschicht entfernt.

Es können verschiedene Entwicklerformulierungen verwendet werden, die entweder zur Klasse der metallionenhaltigen oder metallionenfreien Fotoresistentwickler gehören. Metallionenhaltige Entwickler sind wässrige Lösungen von Natriumhydroxid oder Kaliumhydroxid, die darüber hinaus pH-regulierende und puffernde Substanzen, wie Phosphate oder Silikate sowie Tenside und Stabilisatoren, enthalten können. Metall ionenfreie Entwickler enthalten statt alkalischer Metallverbindungen organische Basen, wie z.B. Tetramethylammoniumhydroxyd oder Cholin. Die Entwicklungszeiten hängen von der Belichtungsenergie, Stärke des Entwicklers, Art des Entwickelns, der Vortrocknungstemperatur und der Entwicklertemperatur ab. Bei der Tauchentwicklung sind Entwicklungszeiten von etwa 1-2 Minuten, bei der Sprühentwicklung von etwa 10-30 Sekunden typisch. Die Entwicklung wird üblicherweise durch Eintauchen oder Besprühen mit einem Nichtlösungsmittel, wie Isopropanol oder deionisiertem Wasser, gestoppt.

Mit den erfindungsgemässen Positiv-Fotoresists vom Polyimid-Typ können Polymerbeschichtungen und kantenscharfe Reliefstrukturen mit Schichtdicken zwischen 0.1 und 500 $\mu$m erhalten werden, wobei Bildauflösungen, je nach Schichtdicke, bis herab zu etwa 1 $\mu$m möglich sind. Durch Temperung bei einer Temperatur zwischen etwa 200 und 400° C wird das Polyamidsäureester-Präpolymer, das den wesentlichen Teil der Fotoresistschicht bzw. Reliefstruktur bildet, durch thermische Imidisierung in Polyimid überführt. Der Schichtdickenverlust während der Temperung ist je nach Anteil an flüchtigen Komponenten mässig bis gering.

Die erfindungsgemässen Positiv-Fotoresists vom Polyimid-Typ verfügen über eine unerwartete und aussergewöhnliche Lagerstabilität, wofür das Fehlen praktisch jeglicher saurer Anteile verantwortlich zu sein scheint. Sie sind über längere Zeit stabil und gebrauchsfähig, ohne dass Veränderungen durch Zersetzungsvorgänge, Reaktionen der Komponenten, Gelieren etc. zu verzeichnen sind. Sie vereinen die hohe Strukturauflösung aufgrund der positiven Arbeitsweise mit der Hochwärmebeständigkeit der damit erzeugbaren Polyimid-Reliefstrukturen.

Gerade in diesen Eigenschaften liegt der besondere Wert der erfindungsgemässen Fotoresists für die praktische Anwendung.

Beispiele

Fotoresist-Formulierungen:

In den nachfolgenden Beispielen werden, sofern dort nicht anders angegeben, die Fotoresistlösungen durch Mischen der in der nachfolgenden Tabelle angegebenen Komponenten und anschliessende Feinfiltration durch Filter mit 1 $\mu$m Porenweite hergestellt.

| Formulierung | A | B | C |
|---|---|---|---|
| Polyamidester-Präpolymer (Polykondensat aus Pyromellithsäuredianhydrid, 4,4'-Diaminodiphenylether und 2-Hydroxyethylmethacrylat gemäss DE-PS 24 37 348) | 2,0 g | 4,0 g | 4,0 g |
| 1,2-Naphthochinondiazid-5-sulfonyltrisester von 1,3,5-Trihydroxybenzol | 2,0 g | 3,0 g | 0,4 g |
| N-Methylpyrrolidon | 6,0 g | 7,0 g | 7,0 g |

Versuchsmethodik:

Die Fotoresist-Formulierungen werden auf oberflächlich oxidierte Silizium-Scheiben von 4 Zoll(= 100 mm) Durchmesser aufgeschleudert und auf einer Heizplatte bei 100° C getrocknet.

Die Belichtung erfolgt polychromatisch (Gerät: Süss MJB 55; Hg-Höchstdrucklampe; Lampenleistung 4,8 mW/cm$^2$) durch eine Auflösungstestmaske mit Strukturen (Gräben und Stege) zwischen 1 und 100 $\mu$m im Vakuumkontakt mit zusätzlicher Stickstoffspülung, wobei die Belichtungsenergien bei 365 nm mit einer Messsonde registriert werden.

Entwickelt wird im Tauch- oder Sprühverfahren mit einem Gemisch aus gleichen Teilen 2%iger wässriger Lösung von Tetramethylammoniumhydroxid und Isopropanol und gestoppt wird mit Isopropanol

6

oder deionisiertem Wasser.

Beispiel 1:

| Formulierung A | |
|---|---|
| Beschichtung: | 2000 Upm/30″ (Umdrehungen per Minute/Sekunde) |
| Vortrocknung: | 2' (Minute) |
| Schichtdicke: | 3,3 $\mu$m |
| Belichtungsenergie: | 1320 mJ/cm$^2$ |
| Entwicklung: | Tauchentwicklung 2' |

Es werden Maskenstrukturen bis herab zu 2 $\mu$m bildgetreu und kantenscharf wiedergegeben.

Beispiel 2:

| Formulierung A | |
|---|---|
| Beschichtung: | 2000 Upm/30″ |
| Vortrocknung: | 2' |
| Schichtdicke: | 3,3 $\mu$m |
| Belichtungsenergie: | 1980 mJ/cm$^2$ |
| Entwicklung: | Sprühentwicklung/90″ |

Es werden Maskenstrukturen bis herab zu 2 $\mu$m bildgetreu und kantenscharf wiedergegeben.

Beispiel 3:

| Formulierung B | |
|---|---|
| Beschichtung: | 3000 Upm/30″ |
| Vortrocknung: | 3' |
| Schichtdicke: | 5,7 $\mu$m |
| Belichtungsenergie: | 615 mJ/cm$^2$ |
| Entwicklung: | Tauchentwicklung/2' |

Es werden Maskenstrukturen bis herab zu 1,75 $\mu$m bildgetreu und kantenscharf wiedergegeben.
Nach Temperung (30 Minuten Aufheizen auf 250° C/30 Minuten 250° C/30 Minuten Aufzeizen auf 400° C) haben die in Polyimid umgewandelten Reliefstrukturen eine Schichtdicke von 3,2 $\mu$m ohne Verlust an Auflösung und Kantenschärfe.

Beispiel 4:

| Formulierung C | |
|---|---|
| Beschichtung: | 3000 Upm/30" |
| Vortrocknung: | 2' |
| Schichtdicke: | 3,5 μm |
| Belichtungsenergie: | 263 mJ/cm² |
| Entwicklung: | Tauchentwicklung/7' |

Es werden Maskenstrukturen bis herab zu 1,75 μm bildgetreu und kantenscharf wiedergegeben.

### Ansprüche

1. Positiv arbeitende, wässrig-alkalische entwickelbare Fotoresists zur Erzeugung von Reliefstrukturen aus hochwärmebeständigen Polyimid-Polymeren, enthaltend in einem organischen Lösungsmittel im wesentlichen mindestens je
a) ein in Polyimid überführbares Präpolymer,
b) eine strahlungsempfindliche Chinondiazid-Verbindung
sowie gegebenenfalls weitere übliche Zusatzstoffe, dadurch gekennzeichnet, dass das Präpolymer ein vollständig verestertes Polyamidsäure-Polymer ist.

2. Fotoresistzusammensetzungen nach Anspruch 1, dadurch gekennzeichnet, dass sie 45-95 Gew.% an Präpolymer und 55-5 Gew.% an Chinondiazid-Verbindung, bezogen auf den Gesamtfeststoffgehalt, enthalten.

3. Verfahren zur Herstellung von Reliefstrukturen aus hochwärmebeständigen Polyimid-Polymeren durch Beschichten eines Substrates mit einer Fotoresistlösung, Trocknen der Schicht, bildmässiges Belichten der Schicht mit UV-Strahlung einer Wellenlänge zwischen 250 und 450 nm, Entwicklung durch Ablösen der bestrahlten Schichtteile mit einer wässrig-alkalischen Entwicklerlösung sowie Tempern der erhaltenen Reliefstrukturen, dadurch gekennzeichnet, dass ein positiv arbeitender Fotoresist nach einem der Ansprüche 1 oder 2 verwendet wird.

4. Reliefstrukturen aus hochwärmebeständigen Polyimid-Polymeren, hergestellt durch Beschichten eines Substrates mit einer Fotoresistlösung enthaltend einen positiv arbeitenden Fotoresist gemäss Anspruch 1, Trocknen der Schicht, bildmässiges Belichten der Schicht mit UV-Strahlung einer Wellenlänge zwischen 250 und 450 nm, Entwicklung durch Ablösen der bestrahlten Schichtteile mit einer wässrig-alkalischen Entwicklerlösung sowie Tempern der erhaltenen Reliefstrukturen.